# EUROPEAN PATENT APPLICATION

(11) **EP 4 521 461 A1**
(43) Date of publication of application: **12.03.2025**
(21) Application number: 24174013.3
(22) Date of filing: 03.05.2024
(51) Int. Cl.: H01L 23/544, H01L 23/15, H01L 23/373, H01L 23/538

(54) **A CERAMIC SUBSTRATE EQUIPPED WITH A UNIQUE CODE FOR A HEAT DISSIPATION SUBSTRATE, A HEAT DISSIPATION SUBSTRATE EQUIPPED WITH A UNIQUE CODE FOR A POWER SEMICONDUCTOR MODULE, AND A POWER SEMICONDUCTOR MODULE INCLUDING A HEAT DISSIPATION SUBSTRATE EQUIPPED WITH A UNIQUE CODE**

(30) Priority: 07.09.2023 KR 20230118847
(71) Applicant: LX Semicon Co., Ltd., Daejeon 34027 (KR)
(72) Inventor: JANG, Min Yup, 34027 Daejeon (KR)
(74) Representative: Goddar, Heinz J.

(57) **Abstract**

The embodiment relates to a power converter including a power semiconductor module and a power semiconductor module equipped with a unique code, and a method of manufacturing the same comprising a ceramic substrate for a heat dissipation substrate with a unique code, a heat dissipation substrate for a power semiconductor module with a unique code, a power semiconductor module including a heat dissipation substrate with a unique code.

A ceramic substrate for a heat dissipation substrate for a power semiconductor according to an embodiment includes an effective area of the ceramic substrate, a dummy area of the ceramic substrate disposed outside the effective area and a unique code marked on the dummy area of the ceramic substrate.

## Description

### TECHNICAL FIELD

The embodiment relates to a ceramic substrate for a heat dissipation substrate, a heat dissipation substrate for a power semiconductor module, a power semiconductor module including the same, a power converter including the same, and a method of manufacturing the same.

Specifically, embodiment include a ceramic substrate for a heat dissipation substrate with a unique code, a heat dissipation substrate for a power semiconductor module with the unique code, a power semiconductor module including a heat dissipation substrate with the unique code, and a power converter including the power semiconductor module with the unique code and method of manufacturing the same.

### BACKGROUND

The power converter module is a device that performs power conversion (AC->DC, DC->AC), power transformation (step-down, step-up), power distribution, or power control. And the power converter module is a key component that improves energy efficiency in the process of transmitting and controlling power and provides system stability and reliability by controlling voltage changes. And the power converter module is referred to as power modules or power systems.

The power converter module includes various components such as power semiconductor devices, heat dissipation substrates, base plates, molding silicon, cases and covers, and terminals.

Recently, eco-friendly vehicles based on electricity or hydrogen have been in the spotlight instead of fossil fuel-based internal combustion engine vehicles, and numerous power semiconductor devices are used in these eco-friendly vehicles. Eco-friendly vehicles include hybrid vehicles (HEV), plug-in hybrid vehicles (PHEV), electric vehicles (EV), and fuel cell vehicles (PCEV).

In addition, a power semiconductor is used in a variety of electrical and electronic devices, such as electric vehicle chargers, energy storage devices, power supply devices, and railroads, in addition to eco-friendly vehicles.

Previously, silicon (Si) power semiconductor devices have been widely used, but as Si power semiconductors have reached their physical limits, to replace this, research is being actively conducted on WBG (wide bandgap) power semiconductors such as silicon carbide (SiC) or gallium nitride (GaN).

WBG power semiconductor devices have a bandgap energy that is about 3 times higher than that of Si power semiconductor devices, a breakdown field that is about 10 times higher than that of Si power semiconductor devices, and thermal conductivity that is about 3 times higher than that of Si power semiconductor devices. Due to these excellent characteristics, the WBG power semiconductor device can operate in a high temperature and high voltage environment and has the advantage of high switching speed and low switching loss.

For example, Si-based power semiconductor modules used to perform power conversion (DC↔AC), motor drive switching, and control in conventional electric vehicles, hybrid electric vehicles, etc. were operated in a temperature environment of around 150°C. In response to recent demands for increased switching performance and power density, research has been actively conducted on wide band gap (WBG)-based power semiconductor devices such as SiC or GaN that can operate at operating temperatures above approximately 300°C, for example, approximately 300~700°C.

Meanwhile, the heat generated from the power semiconductor generates thermomechanical stress in each part of the power semiconductor module, and the life of the bonding and the power semiconductor device may be deteriorated due to thermal fatigue of the bonding. Therefore, it is very important to design the reliability of the power semiconductor module to properly dissipate the heat generated from the power semiconductor device through the heat dissipation substrate to maintain the bonding temperature of the power semiconductor device below an appropriate temperature.

Meanwhile, the heat dissipation substrate for power semiconductors not only has the function of transferring heat generated during operation of power semiconductor devices to the outside, but also has an important function of electrically connecting power semiconductor devices by forming a wiring pattern on one side of the heat dissipation substrates.

Conventional heat dissipation substrates for power semiconductors can be classified into direct bonded copper (DBC) and active metal brazing (AMB) methods depending on the bonding method. The DBC method is a method of forming an oxide film on the copper (Cu) layer and then bonding it directly to the ceramic. The AMB method is a method of performing brazing by interposing a paste containing metal particles with a relatively low melting point between the base metal and ceramic as an intermediate material.

Meanwhile, in the current field of heat dissipation substrates, thickness of supplied ceramic substrates is not constant, and thickness of supplied metal plate, such as copper plates, is also not constant. In this situation, the final heat dissipation substrates must comply with the strict specifications for heat dissipation substrates delivery standards, but there are many difficulties in producing heat dissipation substrates that can meet the strict thickness specifications.

In addition, in the conventional heat dissipation substrate industry, all production and quality information and history, such as ceramic substrate thickness information, inspection information, copper plate thickness information, surface information, and interface information after the bonding process, are not accurately matched and managed for each 'individual heat dissipation substrate'.

Meanwhile, in particular, when metal is sputtered on a ceramic substrate and then a copper plate and hot press process are performed, even if a predetermined code is marked on a ceramic substrate, the code is obscured by the sputtering process and the hot press process, so it was not possible to attempt to mark a separate code for each 'individual heat dissipation substrate'.

Meanwhile, internal technology relied on manual work for the ceramic substrate and metal plate stacking process. Meanwhile, when the stacking process was carried out manually, it was difficult to consider matching the thickness of each the ceramic substrate and metal plate, and even controlling the placement of the metal plate on the upper and lower sides of the ceramic substrate was not easy.

In particular, in the internal technology, the stacked set of the heat dissipation substrate includes a ceramic substrate and a metal plate disposed on the top and bottom, and in realizing a high stacking degree of tens to close to 100 sets, the alignment of the ceramic substrate and the metal plate was studied as a difficult technical challenge.

### SUMMARY

One of the technical objects of the embodiment is to solve the problem of difficulty in meeting the strict thickness specifications of the final heat dissipation substrate in a situation where the thickness of the technical challenge ceramic substrate is not constant and the thickness of the technical challenge metal plate is also not constant.

In addition, one of the technical objects of the embodiment is to accurately match all production and quality information and history, such as ceramic substrate thickness information, inspection information, copper plate thickness information, surface information, and bonding interface information after the bonding process, for each 'individual heat dissipation substrate'.

The technical objects of the embodiments are not limited to those described in this section, but include those that can be understood through the description of the invention.

A method of manufacturing a heat dissipation substrate for a power semiconductor according to an embodiment may include the steps of loading a ceramic substrate including an active area AA of the ceramic substrate and a dummy area DA of the ceramic substrate disposed outside the active area AA and marking a unique code UC on the dummy area DA of the ceramic substrate.

Additionally, the embodiment may further include cleaning the ceramic substrate and measuring a thickness of the cleaned ceramic substrate.

The unique code may be stored in a predetermined central server, and the unique code may include thickness information of the ceramic substrate.

The method may further include marking a unique ID on the dummy area DA of the ceramic substrate.

The unique ID may include a combination of numbers, letters, or a combination of numbers and letters.

The unique code UC has a rectangular or square shape, and may be arranged so that the vertices of the unique code and the vertices of the active area face each other.

The unique code UC may include a rectangular or square shape, and the minimum distance between the unique code and the active area AA of the ceramic substrate may be the distance between a vertex of the unique code and a vertex of the active area.

The unique code UC may have a rectangular or square shape, and the corners of the unique code UC may be arranged to face the active area vertices closest to the unique code.

Additionally, the embodiment may further include the steps of classifying ceramic substrates into a plurality of groups according to the measured thickness, and loading the classified ceramic substrates into different substrate magazines.

Each of the substrate magazines may be marked with a predetermined unique ID or unique code.

Additionally, the embodiment may include the steps of mounting the loaded ceramic substrates on a predetermined sputtering device and sputtering on the mounted ceramic substrates.

In the sputtering step, sputtering may not occur on the unique code.

In addition, the embodiment may include the steps of stacking first and second metal plates on the lower and upper sides of the sputtered ceramic substrate, respectively, performing a hot press process on the stacked ceramic substrate and the first and second metal plates, and removing a portion of the second metal plate to open the unique code.

Additionally, the embodiment may include the steps of forming a wiring pattern through etching on the second metal plate of the ceramic substrate and marking a second unique code on the first metal plate.

The thickness of the first metal plate and the thickness of the second metal plate may be different from each other.

In addition, the method of manufacturing a power semiconductor module according to an embodiment may include the step of disposing a power semiconductor device and bonding a first and a second heat dissipation substrate to the lower and upper sides of the power semiconductor device, respectively.

The method of manufacturing the first heat dissipation substrate or the second heat dissipation substrate may include a method of manufacturing any of the heat dissipation substrates for a power semiconductor module.

The ceramic substrate for a heat dissipation substrate according to an embodiment may include an active area AA of the ceramic substrate, a dummy area DA of the ceramic substrate disposed outside the active area AA, and a unique code UC marked on the dummy area DA of the ceramic substrate.

The unique code UC may include one or more of a digital matrix code (DMC), a QR code, or a bar code.

The embodiment may further include a unique ID marked on the dummy area DA of the ceramic substrate.

The unique ID may include a combination of numbers, letters, or a combination of numbers and letters.

The unique code UC may include a rectangular or square shape.

The vertex of the unique code and the vertex of the active area may be arranged to face each other.

The minimum distance between the unique code and the active area AA of the ceramic substrate may be the distance between a vertex of the unique code and a vertex of the active area.

The corners of the unique code UC may be arranged to face the vertices of the active area closest to the unique code.

A heat dissipation substrate according to an embodiment may include a first metal plate, a ceramic substrate bonded to the first metal plate, and a second metal plate bonded to the ceramic substrate.

A unique code marked on the first metal plate or the second metal plate may be included.

The second metal plate may be electrically connected to a predetermined power semiconductor device.

The unique code may be provided on the first metal plate.

The thickness of the first metal plate and the thickness of the second metal plate may be different from each other.

Additionally, the power semiconductor module according to the embodiment may include a first heat dissipation substrate, a power semiconductor device disposed on the first heat dissipation substrate, and a second heat dissipation substrate disposed on the power semiconductor device.

The first heat dissipation substrate or the second heat dissipation substrate may include one of the heat dissipation substrates for a power semiconductor module.

The second metal plate is electrically connected to the power semiconductor device, and the unique code may be provided on the first metal plate.

The thickness of the first metal plate and the thickness of the second metal plate may be different from each other.

Additionally, the power converter according to the embodiment may include any of the above power semiconductor modules.

According to the embodiment, there is a technical effect in managing heat dissipation substrates by accurately matching and updating all production and quality information and history such as thickness information of ceramic substrate, inspection information, thickness information of copper plate, surface information, bonding interface information after bonding process, etc. for each 'individual heat dissipation substrate'.

For example, according to an embodiment, unique information can be marked on the dummy area of the initial ceramic substrate during the heat dissipation substrate manufacturing process, and the unique information can be stored and managed on a central server to store all production, so that, there is a special technical effect of being able to accurately match and update all production and quality information and history in the heat dissipation substrate manufacturing process by 'individual ceramic substrate', 'individual metal plate', and 'individual heat dissipation substrate'.

In addition, according to the embodiment, even if the position or arrangement of the ceramic substrate changes due to an operator's mistake during the manufacturing process, it is possible to check the unique information of the individual ceramic substrate in all processes through application of the embodiment. And verifying the unique information of the ceramic substrate, there is a technical effect of being able to completely update and manage the history of all processes, including the initial receipt of individual ceramic substrates, cleaning stages, and hot pressing.

In addition, according to an embodiment, unique information that can confirm information about the history of all processes from the initial warehousing stage of the product can be perfectly matched to the final product and delivered to the customer, and the customer can also accurately understand and use the product quality and production history through the unique information, or make requests for after-sales service quickly and accurately when necessary.

Meanwhile, simply marking product information on the heat dissipation substrate of the final product cannot perfectly match and manage the film formation information, such as the thickness information of the ceramic substrate that constitutes the product, the thickness information of the metal plate, and the bonding interface information.

In addition, according to the embodiment, there is a technical effect of minimizing thickness distribution by classifying individual ceramic substrates and metal plates by thickness and matching them by thickness grade.

For example, according to the embodiment, ceramic substrates may be classified and loaded into the first to third substrate magazines CM1, CM2, and CM3 according to thickness, and the thickness and classification loading information for 'individual ceramic substrates' and 'individual substrate magazines' can be stored and managed on the upper server. In addition, the unique information UC of each ceramic substrate SS can be precisely updated and managed with information about which substrate magazine it was loaded into.

Accordingly, in the stacking process conducted after the sputtering process, by reading the unique IDs of the first to third substrate magazines CM1, CM2, and CM3, there is a technical effect of optimizing the thickness quality of the heat dissipation substrate through matching stacking and bonding processes for each thickness with the metal plate.

In addition, the embodiment closely measures and manages the thickness of ceramic substrates and copper plates delivered in various thicknesses to perfectly manage this thickness information so that it can be matched to each product through unique information, and there is a technical effect that can minimize thickness distribution based on this unique information.

The technical effects of the embodiments are not limited to those described in this item and include those that can be understood through the description of the invention.

### BRIEF DESCRIPTION OF THE DRAWINGS

FIG. 1 is a cross-sectional view of a power semiconductor module 500 including a heat dissipation substrate for power semiconductors according to an embodiment.
FIG. 2 is a process flow chart of a heat dissipation substrate manufacturing process for power semiconductors according to an embodiment.
FIGS. 3 to 9 are diagrams of a pretreatment process for a ceramic substrate.
FIGS. 10 to 13 are diagrams of a sputtering process for a ceramic substrate according to an example.
FIG. 14 is a view of a metal magazine (MM) in which metal plates classified by thickness are loaded.
FIG. 15 is a conceptual diagram of a stacked set stacked within a stacking unit.
FIGS. 16 and 17 are diagrams of a hot press bonding process according to an embodiment.
FIG. 18 is an exemplary diagram of a heat dissipation substrate after an inspection process and an etching process.
FIGS. 19 to 21 are diagrams of a laser scribing process, inspection process, and cutting process for a heat dissipation substrate.
FIG. 22 is a circuit diagram of a power converter according to an embodiment.

### DETAILED DESCRIPTION

Hereinafter, embodiments are described in detail with reference to the drawings.

The suffixes "module" and "unit" for the elements used in the following description are simply given in consideration of ease of writing this specification, and do not themselves give a particularly important meaning or role. Accordingly, the "module" and "unit" can be used interchangeably.

Terms including ordinal numbers, such as first and second, can be used to describe various elements, but the elements are not limited by the terms. These terms are only used for the purpose of distinguishing one element from another.

Singular expressions include plural expressions unless the context clearly dictates otherwise.

In this application, terms such as "comprise", "have" or "include" are intended to designate that there is a feature, number, step, operation, component, part, or combination thereof described in the specification, and it is not precluded from being excluded one or other features, numbers, steps, operations, components, parts, or combinations thereof, or any combination thereof.

In an embodiment, the power semiconductor module and the heat dissipation substrate for power semiconductor may be used in inverters or converters such as automobiles, computers, home appliances, solar power, and smart grids. In addition, the power semiconductor module and the heat dissipation substrate for power semiconductor according to the embodiment can be applied to various electrical and electronic devices such as electric differential car chargers, power supply devices, or railways, in addition to eco-friendly vehicles.

In the embodiment, a power semiconductor device may include one power semiconductor module or a plurality of power semiconductor modules. Additionally, the power semiconductor module may include a plurality of power semiconductor devices.

In the following embodiments, the power semiconductor device describes an automobile inverter for driving a motor, but the power semiconductor device of the embodiment can be applied to inverters or converters in the various technical fields described above. Here, vehicles include hybrid vehicles (HEV), plug-in hybrid vehicles (PHEV), electric vehicles (EV), and fuel cell vehicles (PCEV). In the description of the following embodiments, switching devices and power semiconductor devices may be used interchangeably.

### <Power semiconductor module including heat dissipation substrate>

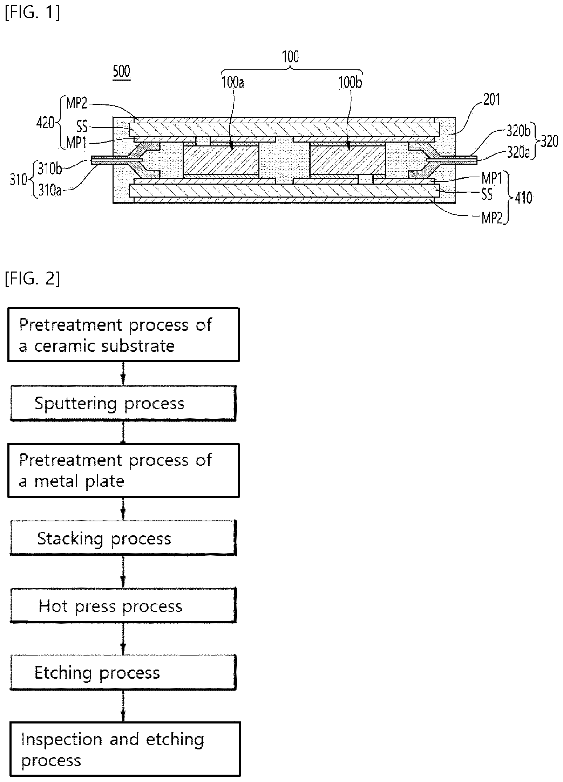

FIG. 1 is a cross-sectional view of a power semiconductor module 500 including a heat dissipation substrate for a power semiconductor according to the embodiment. Referring to FIG. 1, the power semiconductor module 500 according to the embodiment may include a first heat dissipation substrate 410, a second heat dissipation substrate 420, a power semiconductor device 100, a first lead frame 310, a second lead frame 320 and, may be package by a mold 201, but is not limited to. The power semiconductor device 100 may include a first power semiconductor device 100a and a second power semiconductor device 100b.

The first heat dissipation substrate 410 and the second heat dissipation substrate 420 may include a first metal plate MP1, a ceramic substrate SS, and a second metal plate MP2.

One side of each of the first lead frame 310 and the second lead frame 320 may be electrically connected to the power semiconductor device 100, and the other side of each may be connected to an external connection terminal. External connection terminals may include input power, motors, or inverter controllers.

For example, the first lead frame 310 may include a first-first lead frame 310a and a first-second lead frame 310b.

Additionally, the second lead frame 320 may include a second-first lead frame 320a and a second-second lead frame 320b.

### <Manufacturing process of heat dissipation substrate for power semiconductors>

FIG. 2 is a schematic process flow chart of a manufacturing process for a heat dissipation substrate for a power semiconductor according to an embodiment.

The manufacturing process of a heat dissipation substrate for a power semiconductor according to the embodiment may include steps of ① a pretreatment process of a ceramic substrate, ② a sputtering process, ③ a metal plate pretreatment process, ④ a stacking process of a ceramic substrate and a metal plate, (5) a hot press process of a ceramic substrate and a metal plate, (6) an etching process of the heat dissipation substrate, ⑦ inspection and cutting process of the heat dissipation substrate, etc.

The overall manufacturing process of the heat dissipation substrate for power semiconductors according to the embodiment may be controlled by a control unit (not shown) of a central server, and the central server may include a data storage unit (not shown).

Hereinafter, the main manufacturing process of the heat dissipation substrate for power semiconductors according to the embodiment will be described with reference to the drawings.

### (Pre-treatment process of ceramic substrate)

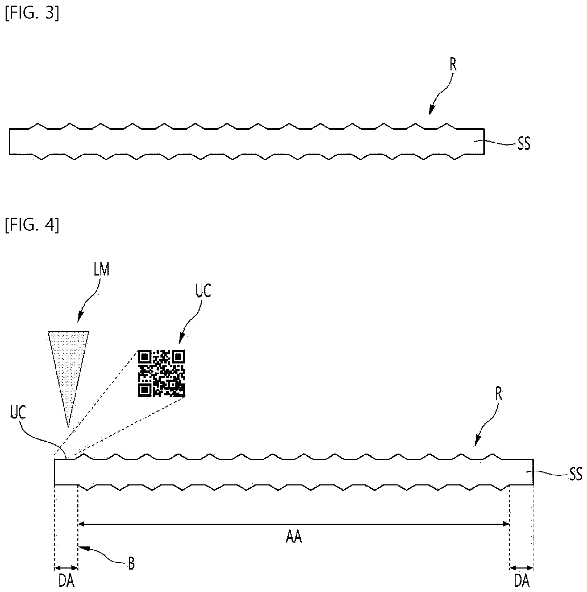

Hereinafter, the pretreatment process of the ceramic substrate will be described with reference to FIGS. 3 to 9.

In the embodiment, the `pretreatment process for a ceramic substrate' may be performed in a substrate cleaning device (not shown) before the ` stacking process' of the ceramic substrate and the metal plate.

The pretreatment process of the ceramic substrate may include ① a loading step of the ceramic substrate, ② an unique code UC marking process, ③ a cleaning process of the ceramic substrate, ④ a thickness measurement process of the ceramic substrate, and (5) a loading process into a magazine for each thickness of the ceramic substrate.

### ① Loading step of ceramic substrate

First, as shown in FIG. 3, the predetermined ceramic substrate SS may be prepared and loaded into the ceramic cleaning device (not shown). The ceramic substrate SS may be AlN, Si₃N₄, or Al₂O₃, but is not limited thereto. The ceramic substrate SS may have irregularities R on its surface, but is not limited thereto.

### ② Unique code UC marking process

In the conventional heat dissipation substrate industry, it was difficult to accurately match overall production and quality history, such as ceramic substrate thickness information, copper plate thickness information, and product information after the bonding process, `for each heat dissipation substrate.'

In particular, when metal sputtering is performed on the ceramic substrate to which present invention is applied, followed by a copper plate and hot press process, even if the code is marked on the ceramic substrate, etc., the code is obscured by the sputtering process and the hot press process. So that there was no attempt to mark separate code for each 'individual heat dissipation substrate'.

Referring to FIG. 4, the unique code UC may be marked on the ceramic substrate SS loaded in the substrate cleaning device. Afterwards, the unique code UC is read, transmitted and stored wired or wirelessly to the data storage unit of the server, and detailed information on the 'individual heat dissipation substrate' including the 'individual ceramic substrate' in the subsequent process can be precisely updated and managed.

Referring to FIG. 4, the ceramic substrate SS may include an active area AA and a dummy area DA. The outermost edge of the active area AA may be the boundary (B) between the active area AA and the dummy area DA.

The active area AA is the area that will be used in the final heat dissipation substrate product in the future, and the dummy area DA is the area that will be removed. The unique code UC may be marked on the dummy area DA of the ceramic substrate SS.

The unique code UC may include, but is not limited to, a digital matrix code (DMC), a QR code, or a bar code. For example, the unique code UC may include a unique code marked or labeled by unique code technology that may emerge through technological development after the application of present invention.

Additionally, the unique code UC may be marked by laser marking (LM) technology, but is not limited thereto.

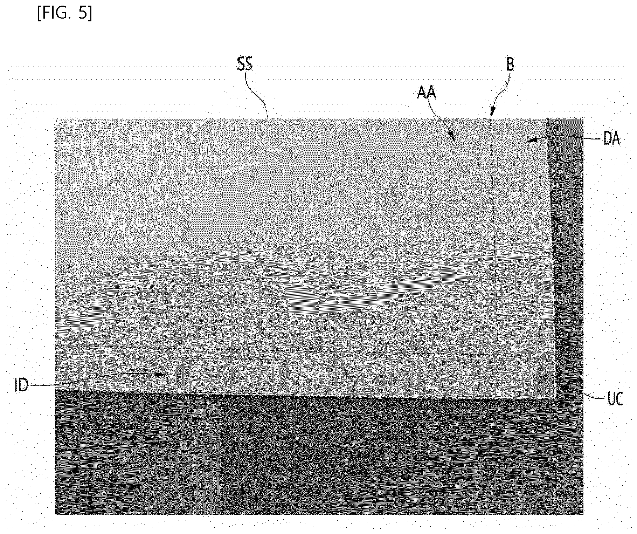

FIG. 5 is a photograph of a ceramic substrate SS on which a unique code UC is marked in the dummy area DA according to an embodiment.

In the embodiment, the unique code UC may be marked on the dummy area DA, which is removed by scribing the ceramic substrate SS, and may be spaced a predetermined distance away from the active area AA.

In the embodiment, in addition to the unique code UC, a unique ID may also be marked in the dummy area DA of the ceramic substrate SS. The unique ID may include a combination of numbers or letters, and may include, but is not limited to, a serial number that can be recognized by an operator or an imaging device.

According to the embodiment, after marking a unique code UC and a unique ID for the entire inserted ceramic substrate SS, it can be transmitted and managed to the data storage of the upper server, detailed information on the 'individual ceramic substrate' and the 'individual heat dissipation substrate' including it can be precisely updated and managed, and there is also a special technical effect that enables post-event management between processes.

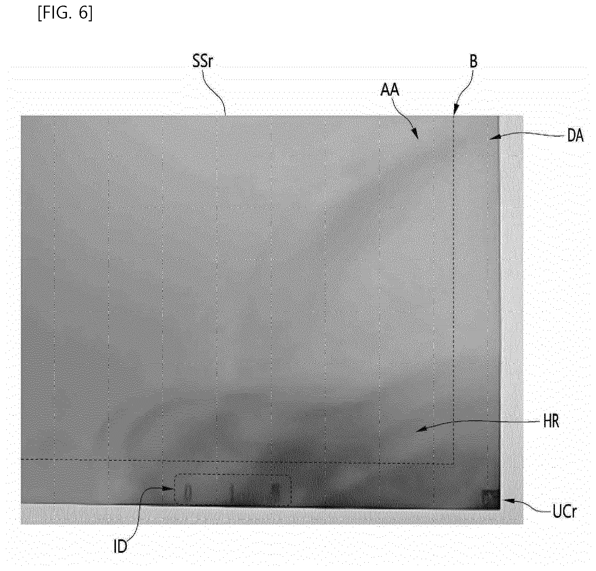

Meanwhile, FIG. 6 is a photograph of a technical problem that occurs when marking a unique code UCr on a ceramic substrate SSr of a comparative example.

In the heat dissipation substrate industry, there has been no concern or attempt to manage the process history of the heat dissipation substrate manufacturing process for individual ceramic substrates.

Meanwhile, the inventors of this application discovered that in the new research process of process history management of the manufacturing process for 'individual ceramic substrates' in the field of heat dissipation substrates, when marking the unique code UCr of the comparative example on a ceramic substrate, a unique problem was discovered in which burning HR occurred and the burning HR could spread beyond the dummy area DA to the active area AA.

This unique technical problem was studied in that burning HR can cause sputtering defects in the later sputtering process, which can be directly related to the quality of the heat dissipation substrate itself, and can further cause bonding defects in the metal plate and hot press process.

Accordingly, not only was it difficult to think of marking a certain unique code on the ceramic substrate itself, but there were significant technical difficulties in implementing it.

Nevertheless, the inventors of this application independently studied the point that burning does not affect the active area when marking the unique code UC, and precisely marked the unique code UC in the dummy area DA without burning, as shown in Figure 5.

In addition, in present invention, marking a unique code on a ceramic substrate causes the unique code to be obscured in the sputtering process and hot press process, so attempts to mark a unique code on an individual ceramic substrate were technically difficult.

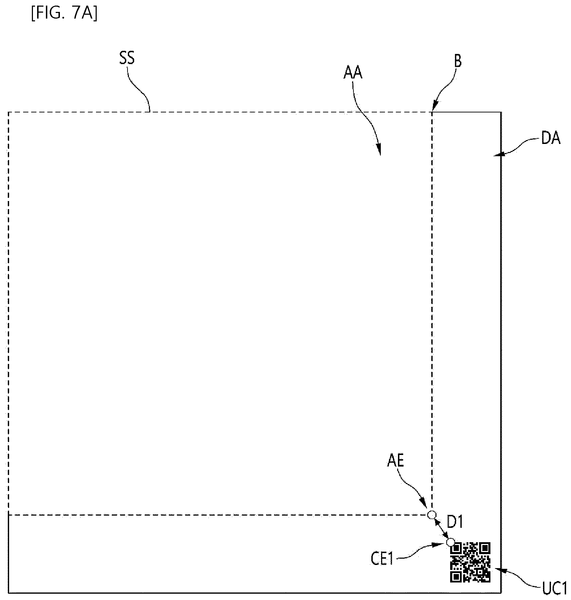

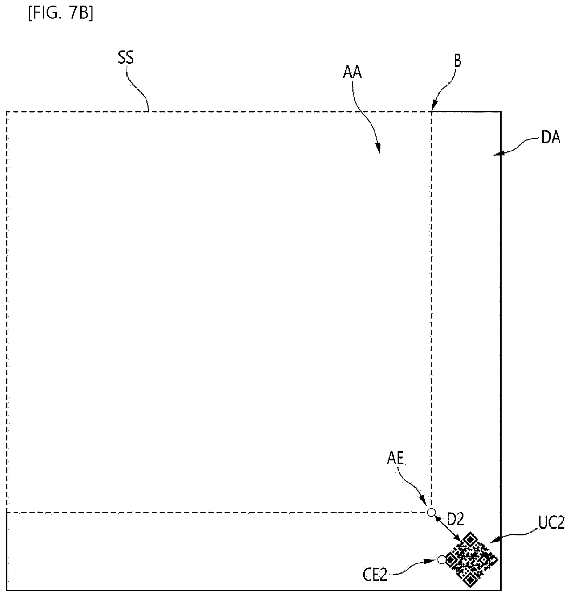

Next, FIG. 7A is a marking diagram of the first unique code UC1 according to the first embodiment, and FIG. 7B is a marking diagram of the second unique code UC2 according to the second embodiment.

The unique code in the embodiment may include a square or rectangular pattern, and may include four corners and four vertices.

Referring to FIG. 7A, the first unique code UC1 and the active area vertex AE of the adjacent ceramic substrate may be spaced apart by a first distance D1. At this time, the vertex of the first unique code CE1 and the vertex of the active area AE may be arranged to face each other.

According to the embodiment, there is a special technical effect in that the production history and product information of each individual ceramic substrate product can be traced by marking a unique code UC on the ceramic substrate SS.

For example, according to the embodiment, a unique code UC and a unique ID can be marked for the entire inserted ceramic substrate SS and then transmitted and managed to the data storage of the upper server, detailed information on 'individual ceramic substrates' and 'individual heat dissipation substrates' containing them can be precisely updated and managed. In addition, there is a special technical effect that enables post-event management between processes.

However, referring to FIG. 7B, through additional research, the inventors of this application placed the second unique code vertex CE2 and the vertex of the active area AE at a distance from each other, so that even if burning occurs, it significantly reduces the possibility of burning spreading to the active area AA by placing the second unique code vertex CE2 and the vertex of the active area AE far apart.

For example, by arranging the side edge of the second unique code UC2 and the vertex AE of the active area to face each other, there is a technical effect of significantly reducing the possibility of burning spreading to the active area AA even if burning occurs.

### ③ Ceramic substrate cleaning process and ④ Thickness measurement process

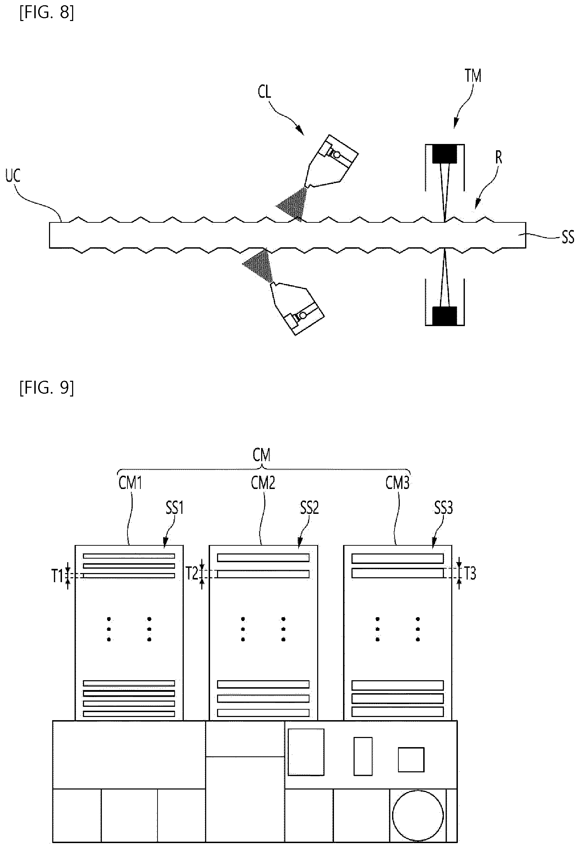

Next, as shown in FIG. 8, after a cleaning process for the ceramic substrate SS using the cleaning device CL, the thickness of the ceramic substrate SS can be measured through the thickness measuring device TM. The thickness of the ceramic substrate SS may be 200µm~1,000µm, but is not limited thereto. Preferably, the thickness of the ceramic substrate SS may be 300µm~800µm, but is not limited thereto.

Ceramic substrates SS can be classified into a plurality of groups depending on their thickness. For example, the ceramic substrate SS may be classified into first to third group ceramic substrates depending on the thickness of the ceramic substrate SS, but is not limited thereto.

### ⑤ Loading process according to the thickness of the ceramic substrate

FIG. 9 is a diagram of a substrate magazine CM in which ceramic substrates classified by thickness after cleaning are loaded according to an embodiment.

For example, ceramic substrates may be classified into first to third groups of ceramic substrates SS1, SS2, and SS3 according to first to third thicknesses T1, T2, and T3.

For example, the thickness of the first group ceramic substrate SS1, the second group ceramic substrate SS2, and the third group ceramic substrate SS3 may be thick in that order, but the thickness is not limited thereto.

The first to third groups of ceramic substrates SS1, SS2, and SS3 may be loaded into the first to third substrate magazines CM1, CM2, and CM3, respectively, and then transferred to a predetermined stacking device. The first to third groups of ceramic substrates may be referred to as first to third lots.

In the embodiment, each of the first to third substrate magazines CM1, CM2, and CM3 may also be marked with a predetermined unique ID or unique code.

According to the embodiment, a ceramic substrate may be classified and loaded into the first to third substrate magazines CM1, CM2, and CM3 according to thickness, and thickness and classification loading information for 'individual ceramic substrates' and 'individual substrate magazines' can be stored and managed on the upper server.

In addition, the unique code UC of each ceramic substrate SS can be precisely updated and managed with information about which substrate magazine it was loaded into.

Accordingly, in the stacking process performed after the sputtering process, by reading the unique IDs of the first to third substrate magazines CM1, CM2, and CM3, the thickness quality of the heat dissipation substrate can be optimized through matching stacking and bonding processes for each thickness with the metal plate.

According to the embodiment, there is a technical effect of minimizing thickness distribution by classifying individual ceramic substrates and metal plates by thickness and matching them by thickness grade.

Currently, in the field of heat dissipation substrates, the thickness of supplied ceramic substrates is not constant, and the thickness of supplied metal plates, such as copper plates, is also not constant.

In this situation, the final heat dissipation substrate must comply with the strict specifications for heat dissipation substrate delivery standards, but there are many difficulties in producing heat dissipation substrate that can meet the strict thickness specifications.

Accordingly, the inventors of present invention invented a stacking system of ceramic substrates and copper substrates which closely measure and manage the thickness of ceramic substrates and copper plates delivered in various thicknesses and perfectly manage this thickness information so that it can be matched to each product through unique information (UC), and based on this unique information UC, thickness distribution can be minimized.

### (Sputtering process)

As described above, the ceramic substrates classified by thickness can be transferred to the sputtering device while loaded in the first to third substrate magazines CM1, CM2, and CM3, and are unloaded for each individual ceramic substrate and then the ceramic substrates may be mounted on a sputtering device and the sputtering process may proceed.

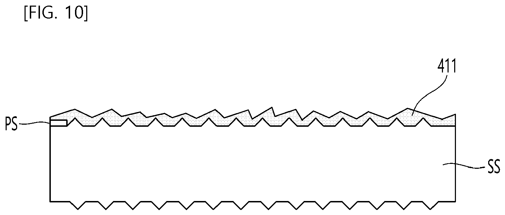

Hereinafter, with reference to FIGS. 10 to 13, the 'sputtering process for a ceramic substrate' of the embodiment will be described.

Referring to FIG. 10, a bonding metal layer 411 of a first thickness may be formed on one surface of the ceramic substrate SS by sputtering.

At this time, sputtering may not be performed in the unique code UC and unique ID areas. For example, in the sputtering process, the unique code UC and the unique ID areas are covered and protected by sprayed parts PS, etc., and then sputtering may be controlled not to proceed in the unique code UC and unique ID areas.

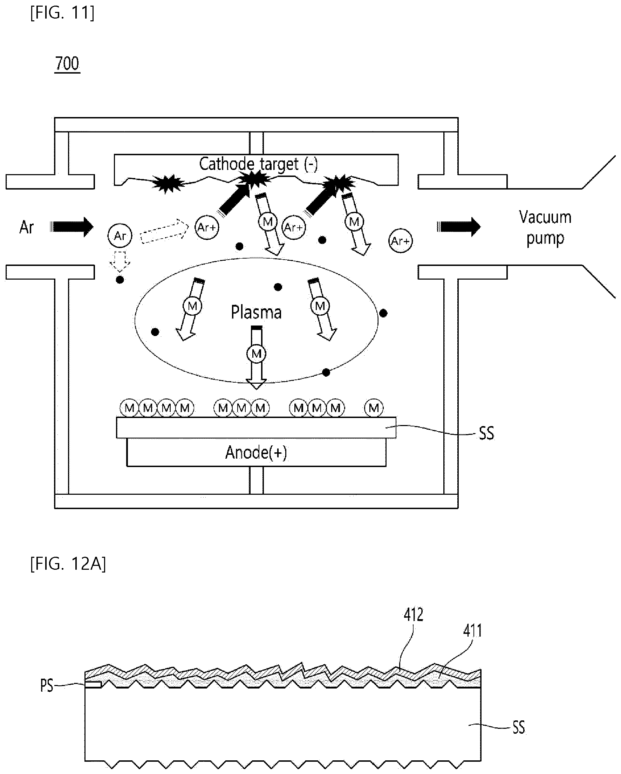

For example, referring to FIG. 11, a ceramic substrate SS is mounted on the anode of a PVD equipment 700, and may be deposited with the bonding metal layer 411 containing Ti or TiW to a first thickness of 2,000Å to 4,000Å in an inert atmosphere such as Ar gas.

For example, the bonding metal layer 411 can be deposited to a thickness of about 2,500Å to 3,500Å, but is not limited thereto.

Next, referring to FIG. 12A, the bonding metal layer 411 and the diffusion metal layer 412 may be formed by sputtering. The diffusion metal layer 412 may be deposited to a second thickness thinner than a first thickness of the bonding metal layer 411 by sputtering.

For example, the second thickness of the diffusion metal layer 412 may range from 1/4 to 1/2 the first thickness of the diffusion metal layer 411.

For example, the second thickness of the diffusion metal layer 412 may be about 1,000 Å or less to 2,000 Å. Preferably, the second thickness of the diffusion metal layer 412 may be about 1,500 Å to 1,900 Å, but is not limited thereto.

The diffusion metal layer 412 may have a melting point lower than the temperature of hot-pressing process for bonding. For example, the temperature of the hot press may range from about 900°C to 1100°C, and the diffusion metal layer 412 may be a material that has a melting point of less than 900°C and has excellent diffusion properties. For example, the diffusion metal layer 412 may be any one or more of Al, Ag, Au, and Sn, but is no limited thereto.

According to the embodiment, as the diffusion metal layer 412 is formed by sputtering to a second thickness thinner than the first thickness of the bonding metal layer 411, there is a technical effect of preventing occurring of micro-voids in the subsequent hot press bonding process.

For example, there is technical effect that the metal materials of the diffused metal layer 412 that was thinly formed in the hot press process can diffuse into the second metal plate (MP2), such as a copper plate, to increase bonding strength and prevent occurring of micro-voids.

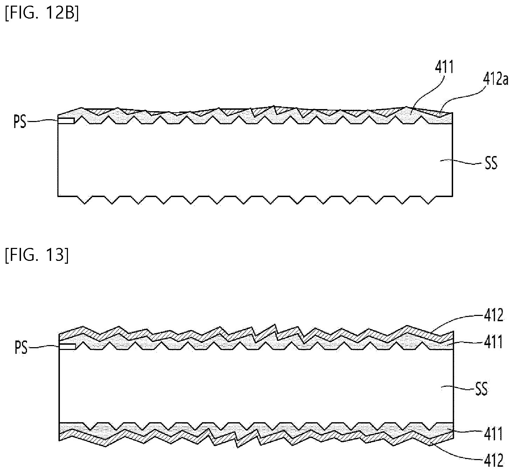

Meanwhile, referring to FIG. 12B, in the embodiment, the diffusion metal region 412a may be formed on the bonding metal layer 411 in the form of an island or a dot, rather than a layer, spaced apart from each other. For example, the diffusion metal region 412a may be formed in the form of islands or dots spaced apart from each other while partially filling the concave portion of the surface irregularities of the bonding metal layer 411.

For example, the diffusion metal region 412a may be formed in the form of islands or dots spaced apart from each other by first filling the concave portion of the surface irregularities of the bonding metal layer 411, which has a relatively high energy state or surface area.

Additionally, in the embodiment, sputtering may be performed with the anode electrode plate of FIG. 11 in a tilted state. Through this, it is possible to control the diffusion metal region 412a to be formed in the form of islands spaced apart from each other while first filling the bottom and sides of the concave portions of the surface irregularities of the bonding metal layer 411.

The diffusion metal region 412a may be formed to a third thickness that is much thinner than the first thickness of the bonding metal layer 411, which is 1/10 to 1/4 the thickness. For example, the third thickness of the diffusion metal region 412a may be about 200Å to 1,000Å. Preferably, the third thickness of the diffusion metal region 412a may be about 500Å to 900Å, but is not limited thereto.

As the diffused metal region 412a is formed on the bonding metal layer 411 in the form of islands or dots, rather than a layer, and spaced apart from each other, the occurrence of micro- voids in the subsequent hot press bonding process is more effectively prevented.

For example, the metal materials in the diffusion metal region 412a, which were deposited in the form of islands or dots in the hot press process, diffuse into the metal plate to increase bonding strength and prevent micro-voids.

Next, referring to FIG. 13, after flipping the ceramic substrate SS on which the diffusion metal layer 412 has been deposited on one surface, the bonding metal layer 411 and the diffusion metal layer 412 can be sequentially formed on the opposite surface by sputtering.

In the embodiment, the thickness of the bonding metal layer 411 and the diffusion metal layer 412 for each individual ceramic substrate SS are measured after sputtering, and the thickness data for each unique code UC is transmitted to the server for update management.

For example, in the embodiment, the thickness of the deposited bonding metal layer 411 and the diffusion metal layer 412 may be measured by measuring the sheet resistance of the individual ceramic substrate SS, but the present invention is not limited thereto.

The individual ceramic substrates for which the thicknesses of the bonding metal layer 411 and the diffusion metal layer 412 have been measured can be transferred to the stacking device loaded again into the first to third substrate magazines CM1, CM2, and CM3, and the thickness of each ceramic substrate and each metal plate can be matched and then stacked in a stacking device.

### (Metal plate pretreatment process)

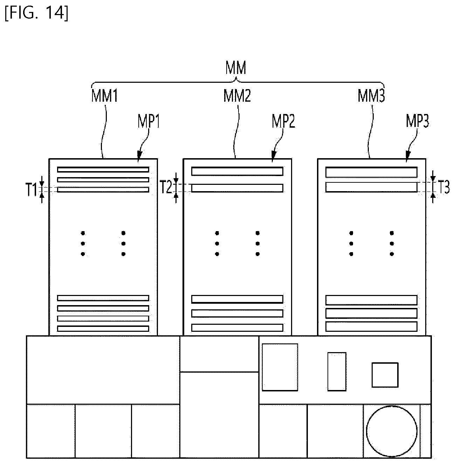

Figure 14 is a diagram of a metal magazine MM in which metal plates classified by thickness after cleaning are loaded according to an embodiment.

The metal plate pretreatment process may be performed separately from the ceramic substrate pretreatment process. For example, the metal plate pretreatment process may be performed before, after, or simultaneously with the ceramic substrate pretreatment process.

The metal plate may be a metal plate with excellent electrical conductivity and thermal conductivity. For example, the metal plate may be a Cu plate or a Cu alloy plate, but is not limited thereto. The metal plate may also be referred to as a metal substrate.

The metal plate pretreatment process may include a cleaning process and a thickness measurement process for the metal plate, and then the metal plates classified by each thickness category may be classified and loaded into a metal magazine.

For example, a CDA (Clean Dried Air) cleaning process and particle exhaust process for the metal plate may be performed.

Additionally, in the embodiment, after cleaning the metal plate, the top/bottom thickness of the metal plate can be measured using a displacement sensor, etc. For example, the thickness of 9 points of a metal plate can be measured, but the method is not limited to this.

At this time, the embodiment may transmit information about the metal plate thickness to the upper server, so that information about individual metal plates may be precisely updated and managed.

Additionally, in the embodiment, a marking procedure for metal-specific information (not shown) may be performed on the dummy area of the metal plate before cleaning, but the process is not limited to this.

In the embodiment, the thickness of the metal plate may be 200µm~500µm, but is not limited thereto. Preferably, the thickness of the metal plate may be 250µm~350µm, but is not limited thereto.

The metal plates may be classified into multiple groups depending on their thickness. For example, the metal plates may be classified into first to third metal plates MP1, MP2, MP3 depending on their thickness, but are not limited thereto. The thickness of the first metal plate MP1, the second metal plate MP2, and the third metal plate MP3 may be increased in that order, but the thickness is not limited to this.

For example, referring to FIG. 14, the first to third groups of metal plates MP1, MP2, and MP3 classified into the first to third thicknesses T1, T2, and T3 are respectively loaded into the first to third metal magazines MM1, MM2, and MM3 and then transferred to a predetermined stacking device. The first to third groups of the metal plates may be referred to as first to third lots.

In the embodiment, each metal magazine MM1, MM2, MM3 may be marked with a predetermined unique ID or unique code.

According to the embodiment, the metal plates may be classified and loaded into first to third metal magazines MM1, MM2, and MM3 according to thickness, and thickness and classification loading information for individual metal plates and metal magazines can be stored and managed on the upper server.

In addition, the unique information of each metal plate can be precisely updated and managed with information about which metal magazine it was loaded into.

Accordingly, in the subsequent stacking process, the unique IDs of the metal magazines MM1, MM2, and MM3 can be read and the thickness quality can be optimized through matching bonding for each thickness with the ceramic substrate.

According to the embodiment, there is a technical effect of classifying not only individual ceramic substrates but also metal plates by thickness and minimizing thickness distribution by matching each thickness grade.

Currently, in the field of heat dissipation substrates, not only the thickness of supplied ceramic substrates but also the thickness of supplied metal plates, such as copper plates, is inconsistent. In this situation, the final heat dissipation substrates must comply with the strict specifications for heat dissipation substrates delivery standards, but there are many difficulties in producing heat dissipation substrates that can meet the strict thickness specifications.

Accordingly, the inventors of present invention closely measure and manage the thickness of ceramic substrates and copper plates delivered in various thicknesses to perfectly manage this thickness information so that it can be matched to each product through unique information. Based on this unique information, a stacking system of ceramic substrates and copper substrates that can minimize thickness distribution was invented.

### (Stacking process of ceramic substrate and metal plate)

Next, the stacking process of the ceramic substrate and the metal plate can proceed.

In the embodiment, the stacking process of the ceramic substrate and the metal plate may include ① loading process of carbon spacer, (2) loading process of lower metal plate, ③ loading process of ceramic substrate, ④ loading process of upper metal plate, (5) loading process of carbon spacer, and ⑩ loading process of graphite.

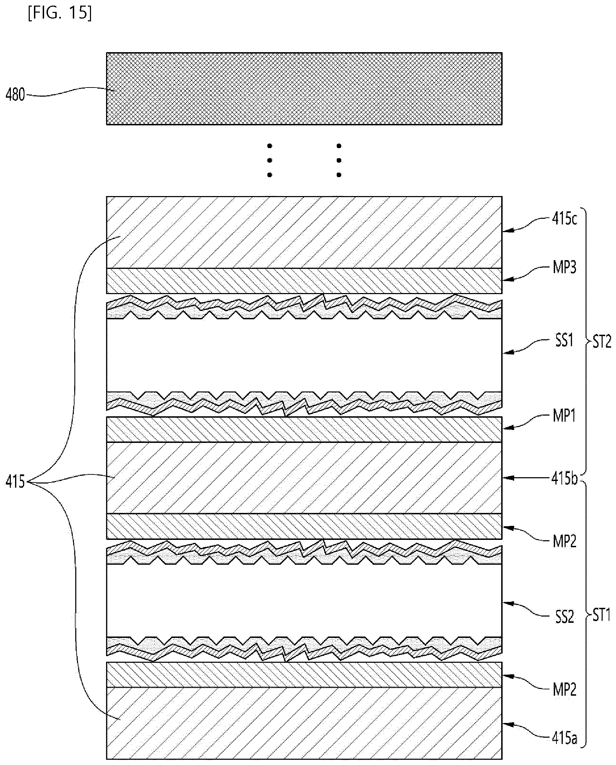

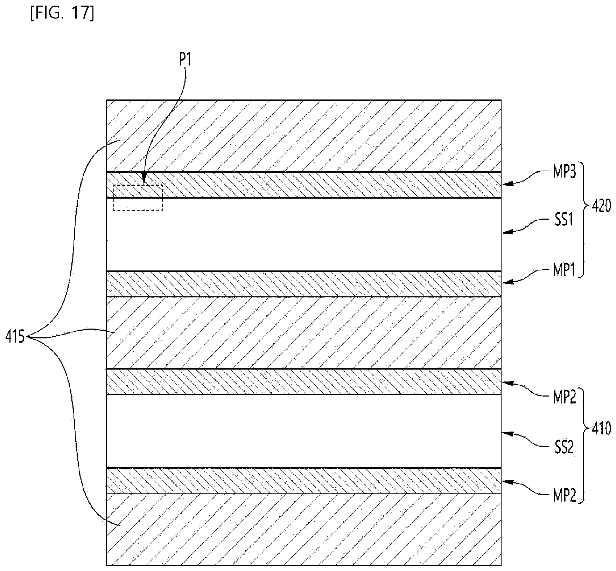

FIG. 15 is a conceptual diagram of a stacking set including a first stacked set ST1 and a second stacked set ST2 stacked in a stacking unit according to the embodiment. The first stacked set ST1 which will be the first heat dissipation substrate 410 (see FIG. 17), may include a first spacer 415a, a second metal plate MP2, a second ceramic substrate SS2, and a second spacer 415b sequentially stacked. In addition, the second stacked set ST2, which will be the second heat dissipation substrate 420 (see FIG. 17), may include a second spacer 415b, a first metal plate MP1, a ceramic substrate SS1, a third metal plate MP3, and a third spacer 415c sequentially stacked.

In the embodiment, a graphite 480 may be stacked after 10 stacked sets are performed, but the method is not limited thereto.

According to the embodiment, a stacked set stacked by an automatic alignment stacking system device may be fastened to a predetermined carrier clamp, and by inserting a predetermined guide transfer device into the stacking carrier, a precisely aligned stacking set can be put into a hot press with the alignment maintained.

### (Hot press process)

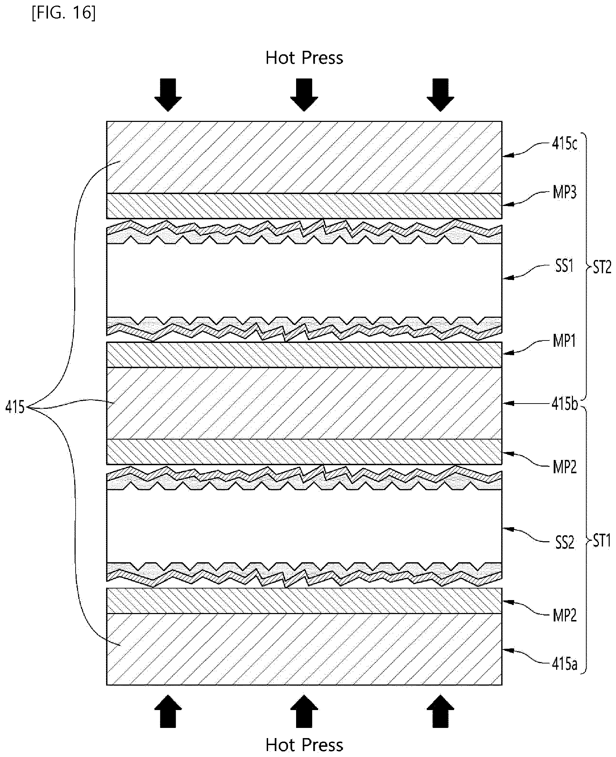

Next, the hot press bonding process of the embodiment will be described with reference to FIGS. 16 to 17.

Referring to FIG. 16, the hot press process may be performed in a vacuum state on the stacking set inputted into a hot press device (not shown), so that heat dissipation substrates 410 and 420 can be manufactured as shown in FIG. 17.

For example, the first stacked set ST1 including the second metal plate MP2, the second ceramic substrate SS2, and the second metal plate MP2 may be manufactured as the first heat dissipation substrate 410.

Additionally, the second stacked set ST2 including the first metal plate MP1, the first ceramic substrate SS1, and the third metal plate MP3 may be manufactured as the second heat dissipation substrate 420.

The temperature of the hot press process may be about 900°C to 1,100°C. Preferably, the temperature of the hot press process may be about 950°C to 1,000°C, but is not limited thereto.

The vacuum degree of the hot press process may be 1.0×10⁻¹ torr or more, but is not limited thereto. Additionally, the pressure of the hot press process may be from about 10 MPa to about 100 MPa, but is not limited thereto.

### (Inspection and etching process of heat dissipation substrate)

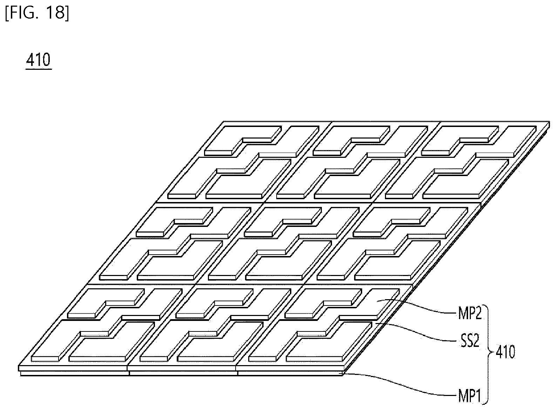

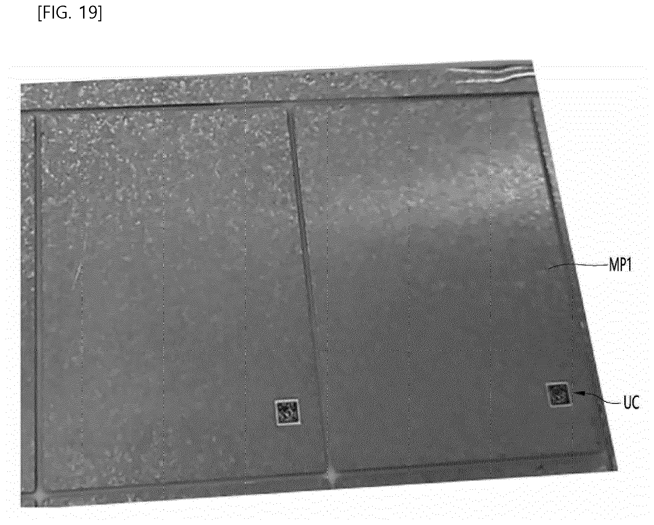

FIG. 18 is an exemplary diagram of a heat dissipation substrate after the inspection process and etching process of FIG. 19.

Referring to FIG. 18, a cleaning process, an inspection process, and an etching process may be performed on each heat dissipation substrate manufactured through the hot press bonding process.

The first heat dissipation substrate 410 shown in FIG. 18 may have a structure including the first metal plate MP1, the second ceramic substrate SS2, and the second metal plate MP2, but is not limited thereto.

For example, the cleaning process may be performed on the first heat dissipation substrate 410 manufactured through the hot press bonding process. For example, a brush cleaning, water washing, and a drying process may be performed on the first heat dissipation substrate 410, but the process is not limited thereto.

Additionally, in the embodiment, an ultrasonic inspection of the bonding interface may be performed on the heat dissipation substrate manufactured by the hot press process.

For example, according to the embodiment, the first bonding interface of each heat dissipation substrate may be inspected for the interface thickness, presence of voids, and cracks using ultrasonic inspection equipment.

According to the embodiment, after the hot press bonding process, a portion of the metal plate in the dummy area of each heat dissipation substrate may be removed to open the unique code UC formed in the dummy area.

This has the special technical effect of being able to precisely update and manage inspection information on the interface thickness, presence of voids, and cracks on the bonding interface of individual heat dissipation substrates after the hot press process.

Continuing with reference to FIG. 18, the etching process to form a circuit pattern may be performed on the heat dissipation substrate determined to be a good product in the inspection process.

For example, a wiring pattern may be formed through the etching process on the first heat dissipation substrate 410 on which a hot press process has been performed. For example, a wiring pattern may be formed by partially removing the second metal plate MP2 of the first heat dissipation substrate 410. The bonding metal layer 411 and the bonding layer 413 on the second ceramic substrate SS2 may also be removed.

The embodiment has a special technical effect in that etching information (etchant, etching process conditions, etc.) for individual heat dissipation substrates can be precisely updated and managed after the hot press process.

### (Inspection and cutting process)

Next, a laser scribing process, an inspection process, and a cutting process for the heat dissipation substrate will be described with reference to FIGS. 19 to 21.

Referring to FIG. 19, the etching inspection may be performed on the heat dissipation substrate for which the etching process has been completed.

For heat dissipation substrates that have a good etching test, the unique code UC may be marked on the metal plate. For example, when one heat dissipation substrate includes 9 snap areas, unique code UC may be marked on the metal plate on which a circuit pattern is not formed for each snap, for example, on each snap of the first metal plate MP1.

Unique code UC marking on each snap area of the first metal plate MP1 may be performed after the laser scribing.

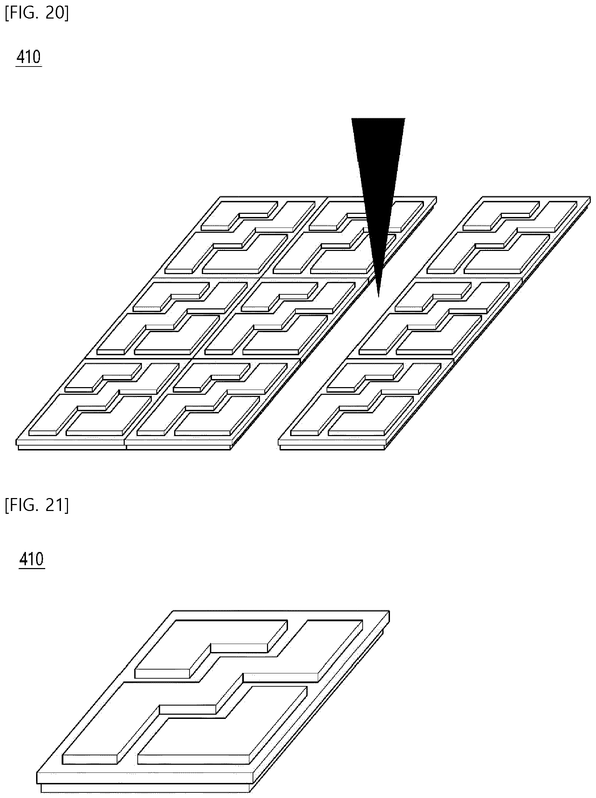

Next, referring to FIG. 20, the laser scribing process and the breaking process may be performed.

In the embodiment, the inspection process may be performed after the laser scribing process and before the breaking process. The inspection process may include ultrasonic testing (SAT), which secondarily inspects voids or cracks at the joint interface using ultrasonic waves.

In addition, the inspection process after the laser scribing process may include a process of analyzing surface information such as surface roughness, surface pinhole inspection, protrusion inspection, and foreign matter inspection through an automatic appearance inspection process.

The embodiment has a special technical effect in that secondary bonding interface inspection information and automatic appearance inspection information for individual heat dissipation substrates can be precisely updated and managed after the etching process.

Thereafter, an individual heat dissipation substrate can be manufactured as shown in FIG. 21 through a cutting and separation process for the final good product. The first metal plate MP1 of the first heat dissipation substrate 410 shown in FIG. 21 may be delivered with the unique code UC marked as shown in the photo of FIG. 19.

Accordingly, according to the embodiment, unique information that can confirm information about the history of all processes from the initial warehousing stage of the product can be perfectly matched to the final product and delivered to the customer, and customers can also accurately understand and use the product quality and production history through the unique information, or make requests for after-sales service quickly and accurately when necessary.

Meanwhile, simply marking product information on the heat dissipation substrate of the final product cannot perfectly match and manage the film formation information, such as the thickness information of the ceramic substrate that constitutes the product, the thickness information of the metal plate, and the bonding interface information.

### <Power converter including heat dissipation substrate>

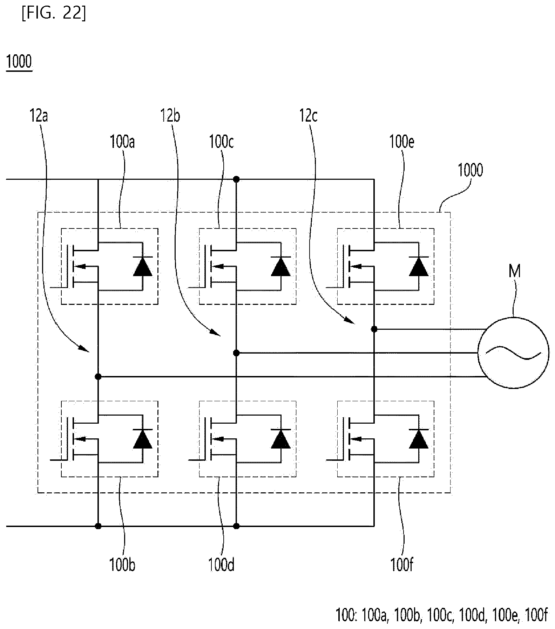

FIG. 22 is a circuit diagram of a power converter 1000 to which a power semiconductor module according to an embodiment is applied.

The power converter 1000 according to the embodiment may receive DC power from a battery or fuel cell and convert it into AC power, and supply AC power to a predetermined load. For example, the power converter 1000 according to the embodiment may include an inverter, receive DC power from a battery, convert it into three-phase AC power, and supply it to the motor M. The motor M can provide power to electric vehicles, fuel cell vehicles, etc.

The power converter 1000 according to the embodiment may include a power semiconductor device 100. The power semiconductor device 100 may be a MOSFET (Metal Oxide Semiconductor Field Effect Transistor), but is not limited thereto, and may include an IGBT (Insulated Gate Bipolar Transistor).

For example, the power converter 1000 may include a plurality of power semiconductor devices 100a, 100b, 100c, 100d, 100e, and 100f, and may include a plurality of diodes (not shown).

In the embodiment, a group of power semiconductor devices arranged in series on the high-voltage line and low-voltage line on the input side may be called an arm. For example, the first and second power semiconductor devices 100a and 100b comprise the first arm 12a, and the third and fourth power semiconductor devices 100c and 100d comprise the second arm 12b, and the fifth and sixth power semiconductor devices 100e and 100f may comprise the third arm 12c.

The power semiconductor device 100 of the embodiment may be a silicon carbide (SiC) power semiconductor device, may operate in a high temperature and high voltage environment, and may have high switching speed and low switching loss. The power semiconductor device 100 of the embodiment may be packaged on the heat dissipation substrate for power semiconductors described above to form a power semiconductor module (see FIG. 1).

According to the embodiment, there is technical effect in that accurately matches and updates management of all production and quality information and history for each 'individual heat dissipation substrate' in the manufacturing of heat dissipation substrates, including ceramic board thickness information, inspection information, copper plate thickness information, surface information, and bonding interface information after the bonding process.

In addition, according to the embodiment, even if the position or arrangement of the ceramic substrate changes due to an operator's mistake during the manufacturing process, through the application of the embodiment, there is a technical effect of being able to completely update and manage the history of all processes, including the initial receipt of the individual ceramic substrate, cleaning step, and hot pressing, by confirming the unique information of the individual ceramic substrate.

In addition, according to the embodiment, unique information that can confirm information about the history of all processes from the initial warehousing stage of the product can be perfectly matched to the final product and delivered to the customer, and customers can also accurately understand and use the product quality and production history through the unique information, or make requests for after-sales service quickly and accurately when necessary.

In addition, according to the embodiment, there is a technical effect of minimizing thickness distribution by classifying individual ceramic substrates and metal plates by thickness and matching them by thickness grade.

Accordingly, in the stacking process that proceed after the sputtering process, there is a technical effect that can optimize the thickness and quality of the heat dissipation substrate by reading the unique IDs of the first to third substrate magazines CM1, CM2, and CM3 and matching the ceramic substrate and metal plate by thickness to perform the stacking and bonding process.

In addition, in the embodiment, the thickness of ceramic substrates and copper plates delivered in various thicknesses are carefully measured and managed to perfectly manage this thickness information so that it can be matched to each product through unique information, and based on this unique information, thickness distribution is minimized.

Although the present invention has been described above with reference to the embodiments, those skilled in the art will easily understand that various modifications and changes can be made to the present invention without departing from the spirit and scope of the present invention as set forth in the claims below.

## Claims

1. A ceramic substrate for a heat dissipation substrate, comprising:
an effective area of the ceramic substrate;
a dummy area of the ceramic substrate disposed outside the effective area; and
a unique code marked on the dummy area of the ceramic substrate.

2. The ceramic substrate according to claim 1, wherein the unique code comprises one or more of a digital matrix code (DMC), QR code, or bar code, and
wherein the unique code comprises thickness information of the ceramic substrate.

3. The ceramic substrate according to claim 1 or claim 2, further comprising a unique ID marked on a dummy area of the ceramic substrate.

4. The ceramic substrate according to claim 3, wherein the unique ID comprises a combination of numbers, a combination of letters, or a combination of numbers and letters.

5. The ceramic substrate according to any one of claims 1 to 4, wherein the unique code comprises a rectangular or square shape, and
wherein a vertex of the unique code and a vertex of the effective area are arranged to face each other.

6. The ceramic substrate according to claim 5, wherein the unique code comprises a rectangular or square shape, and
wherein a minimum distance between the unique code and the effective area of the ceramic substrate is a distance between a vertex of the unique code and a vertex of the effective area.

7. The ceramic substrate according to any one of claims 1 to 6, wherein the unique code comprises a rectangular or square shape, and
wherein an edge of the unique code is disposed to face a vertex of an effective area closest to the unique code.

8. A heat dissipation substrate for a power semiconductor module, comprising:
a first metal plate;
a ceramic substrate bonded to the first metal plate; and
a second metal plate bonded on the ceramic substrate,
a first unique code marked on the first metal plate or the second metal plate.

9. The heat dissipation substrate according to claim 8, wherein the second metal plate is electrically connected to a power semiconductor device, and
wherein the first unique code is provided on the first metal plate.

10. The heat dissipation substrate according to claim 8, wherein a thickness of the first metal plate and a thickness of the second metal plate are different from each other.

11. The heat dissipation substrate according to any one of claims 8 to 10, wherein the ceramic substrate comprises:
an effective area of the ceramic substrate;
a dummy area of the ceramic substrate disposed outside the effective area; and
a second unique code marked on the dummy area of the ceramic substrate.

12. The heat dissipation substrate according to claim 11, wherein the first unique code comprises one or more of a digital matrix code (DMC), QR code, or bar code, and
wherein the first unique code comprises thickness information of the ceramic substrate.

13. The heat dissipation substrate according to claim 11, wherein the second unique code comprises a rectangular or square shape, and
wherein a vertex of the second unique code and a vertex of the effective area are arranged to face each other.

14. The heat dissipation substrate according to claim 11, wherein the second unique code comprises a rectangular or square shape, and
wherein an edge of the second unique code is disposed to face the vertex of the effective area closest to the unique code.

15. A power semiconductor module, comprising:
a first heat dissipation substrate;
a power semiconductor device disposed on the first heat dissipation substrate;
a second heat dissipation substrate disposed on the power semiconductor device,
wherein the first heat dissipation substrate or the second heat dissipation substrate comprises the heat dissipation substrate according to any one of claims 8 to 14.
